(19) **Europäisches Patentamt**
**European Patent Office**
**Office européen des brevets**

(11) **EP 4 726 424 A1**

(12) # EUROPEAN PATENT APPLICATION

(43) Date of publication:
**15.04.2026 Bulletin 2026/16**

(21) Application number: **24205528.3**

(22) Date of filing: **09.10.2024**

(51) International Patent Classification (IPC):
***G01R 31/52*** *(2020.01)*

(52) Cooperative Patent Classification (CPC):
**G01R 31/52;** G01R 31/006

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ABB Schweiz AG**
**5400 Baden (CH)**

(72) Inventors:
- **MOECKLI, Rudolf**
**5300 Turgi (CH)**
- **LONG, Shannon**
**8803 Rüschlikon (CH)**
- **ENGELI, Cornel Paul**
**8005 Zürich (CH)**
- **WICKI, Stefan**
**5702 Niederlenz (CH)**

(74) Representative: **Sykora & König Patentanwälte
PartG mbB
Maximilianstraße 2
80539 München (DE)**

(54) **METHOD, CONTROLLER, AND COMPUTER PROGRAM FOR LOCALIZING AN EARTH-FAULT WITHIN A BATTERY ARRANGEMENT, BATTERY ARRANGEMENT, AND COMPUTER-READABLE MEDIUM**

(57)    A method for localizing an earth-fault (EF) within a battery arrangement (20) is described. The battery arrangement (20) comprises a battery pack (22) having a first pole (30), a second pole (32), and at least two battery cells (34) electrically arranged in series between the first pole (30) and the second pole (32), and a first switch (24) electrically arranged between the first pole (30) and a first resistor (R12), with the first resistor (R12) electrically coupling the first switch (24) to a ground potential (38), and a second switch (26) electrically arranged between the second pole (32) and a second resistor (R22), with the second resistor (R22) electrically coupling the second switch (26) to the ground potential (38). The method comprises: electrically coupling the first pole (30) to the ground potential (38) by the first switch (24), while the second pole (32) is electrically decoupled from the ground potential (38) by the second switch (26); measuring a first voltage between the first switch (24) and the ground potential (38); determining a first voltage value (V1) depending on the measured first voltage, wherein the first voltage value (V1) is representative of the measured first voltage; electrically coupling the second pole (32) to the ground potential (38) by the second switch (26); electrically decoupling the first pole (30) from the ground potential (38) by the first switch (24); measuring a second voltage between the second switch (26) and the ground potential (38); determining a second voltage value (V2) depending on the measured second voltage wherein the second voltage value (V2) is representative of the measured second voltage; determining that an earth-fault (EF) is present at the first pole (30), when the first voltage value (V1) at least approaches zero and the second voltage value (V2) at least approximately corresponds to a given battery voltage of the battery pack (22); determining that an earth-fault (EF) is present at the second pole (32), when the second voltage value (V2) at least approaches zero and the first voltage value (V1) at least approximately corresponds to the battery voltage; and determining that an earth-fault (EF) is present between the first and second poles (30, 32), when the first voltage value (V1) and the second voltage value (V2) are well between zero and the battery voltage, wherein an exact location of the earth-fault (EF) between the first and second poles (30, 32) is determined depending on a ratio determined from the first voltage value (V1) and the second voltage value (V2).

EP 4 726 424 A1

# Fig. 1

**Description**

FIELD OF THE INVENTION

The invention relates to the field of battery arrangements and the monitoring and/or checking of the battery arrangements. In particular, the invention relates to a method, a controller, and computer program for localizing an earth-fault within a battery arrangement, to the battery arrangement, and to a computer-readable medium on which the computer program is stored.

BACKGROUND OF THE INVENTION

Battery arrangements comprising one or more battery packs are increasingly used in very complex products, such as high-voltage DC-links for propulsion applications, for example. The battery packs each may comprise two or more battery cells being arranged electrically in series, for example. The propulsion applications may be used in electric vehicles, e.g., in on-road and/or in off-road vehicles, such as e.g. mining trucks, trains, trams, and subways. For such complex applications it is generally recommendable to check insulation properties of the energy storage systems, in particular of the battery packs, regularly. There already exist Insulation Monitoring Devices (IMDs) for monitoring and/or checking insulation properties of the ESSs in the market. These IMDs may be integrated into Battery Management Systems (BMS) for operating the battery arrangements and/or battery packs or may be provided as separate entities which may communicate with the BMS.

However, the harsh nature of such applications, e.g., of the mining trucks, asks for a robust, but sensitive function to detect system failures and prevent harm from people and material. In addition, it would be advantageous to have a method for identifying an earth-fault within a battery pack in a disconnected state of the battery arrangement in order not to operate a faulty battery arrangement. Further, it would be even more advantageous to know an exact location of the earth-fault within the battery arrangement to be able to improve the design of further generations of battery arrangements and their battery packs.

DESCRIPTION OF THE INVENTION

It is an objective of the present invention to provide a method, a controller, and a computer program for localizing an earth-fault within a battery arrangement, which enable to detect an earth-fault within the battery arrangement, for example in a disconnected state of the battery arrangement, and/or which enable to determine an exact location of the earth-fault within the battery arrangement. It is another objective of the present invention to provide the battery arrangement comprising the controller, and a computer-readable medium on which the computer program is stored.

This objective is achieved by the subject-matter of the independent claims. Further exemplary embodiments are evident from the dependent claims and the following description.

A first aspect relates to a method for localizing an earth-fault within a battery arrangement. The battery arrangement comprises a battery pack, a first switch and a second switch. The battery pack has a first pole, a second pole, and at least two battery cells electrically arranged in series between the first pole and the second pole. The first switch is electrically arranged between the first pole and a first resistor, with the first resistor electrically coupling the first switch to a ground potential. The second switch is electrically arranged between the second pole and a second resistor, with the second resistor electrically coupling the second switch to the ground potential. The method comprises: electrically coupling the first pole to the ground potential by the first switch, while the second pole is electrically decoupled from the ground potential by the second switch; measuring a first voltage between the first switch and the ground potential; determining a first voltage value depending on the measured first voltage, wherein the first voltage value is representative of the measured first voltage; electrically coupling the second pole to the ground potential by the second switch; electrically decoupling the first pole from the ground potential by the first switch; measuring a second voltage between the first switch and the ground potential; determining a second voltage value depending on the measured second voltage wherein the second voltage value is representative of the measured second voltage; determining that an earth-fault is present at the first pole, when the first voltage value at least approaches zero and the second voltage value at least approximately corresponds to a given battery voltage of the battery pack; determining that an earth-fault is present at the second pole, when the second voltage value at least approaches zero and the first voltage value at least approximately corresponds to the battery voltage; and determining that an earth-fault is present between the first and second poles, when the first voltage value and the second voltage value are well between zero and the battery voltage, wherein an exact location of the earth-fault between the first and second poles is determined depending on a ratio determined from the first voltage value and the second voltage value.

A second aspect relates to a controller for localizing the earth-fault within the battery arrangement. The controller comprises: at least one voltmeter being arranged and configured to measure at least two voltages over the battery pack of the battery arrangement; a memory for storing one or more values of the measured voltages; and a processor being communicatively coupled to the memory and being configured to carry out the method in accordance with one of the preceding claims based on the measured voltages.

A third aspect relates to the battery arrangement. The battery arrangement comprises: the battery pack having the first pole, the second pole, and at least two battery cells electrically arranged in series between the first pole and the second pole; the first switch electrically arranged between the first pole and the first resistor, with the first resistor electrically coupling the first switch to the ground potential; and the second switch electrically arranged between the second pole and the second resistor, with the second resistor electrically coupling the second switch to the ground potential; and the controller being communicatively coupled to the voltmeter, the first switch, and the second switch.

A fourth aspect relates to a computer program for localizing the earth-fault within the battery arrangement. The computer program comprises computer-readable instructions, which, when being carried out by the processor of the controller, cause the controller to carry out the method as described above an in the following.

A fifth aspect relates to a computer-readable medium, on which the computer program is stored. The computer-readable medium may be a floppy disk, a hard disk, an USB storage device, a RAM, a ROM, an EPROM or a FLASH memory. The computer readable medium may also be a data communication network, e.g. the Internet, which allows downloading a program code. In general, the computer-readable medium may be a non-transitory or transitory medium.

It has to be understood that some features of the present invention are described with respect to one of the aspects only for conciseness reasons and to avoid unnecessary repetitions, but that these features may be easily transferred to one or more of the other aspects by the person skilled in the art.

The above aspects enable to detect the earth-fault within the battery arrangement in an easy and efficient way, for example in a disconnected state of the battery arrangement, i.e., when the battery arrangement is decoupled from any load to be supplied with energy from the battery arrangement. In addition, the above aspects enable to determine the exact location of the earth-fault within the battery arrangement. In particular, the inventors realized that the first voltage value gets the smaller the closer the earth-fault is to the first pole and that the second voltage value gets the smaller the closer the earth-fault is to the second pole. Therefore, the exact location of the earth-fault between the first and second poles may be determined depending on the above mentioned ratio. Instead of determining the exact location of the earth-fault between the first and second poles depending on the above mentioned ratio, the exact location may be determined depending on a ratio of the first voltage value to the battery voltage and on a ratio of the second voltage value to the battery voltage. This alternative approach is equivalent with respect to the claimed approach, because the battery voltage corresponds to the sum of the first and second voltages and because in both embodiments the same information is processed, but with different mathematical formulas.

The order of the steps of the above method may be altered. In particular, the first voltage should always be measured when the first switch is closed and the second switch is open, and the second voltage should always be measured when the second switch is closed and the first switch is open. However, the second voltage may be measured before measuring the first voltage. In addition, the order of the determining whether the earth-fault is present at the first pole, the second pole, or between the first and second poles may also be altered.

The first pole may be a positive pole of the battery pack, for example. The first pole may be electrically coupled to the ground potential by sending a first coupling signal to the first switch, wherein the first switch and the coupling signal are configured such that the first switch electrically couples the first pole to the ground potential upon receiving the first coupling signal. The first coupling signal may be generated by the controller and may be sent to the first switch by the controller. Alternatively, when the first switch is already electrically coupled to the ground potential, the first coupling signal does not have to be sent to the first switch.

The first pole may be electrically decoupled from the ground potential by sending a first decoupling signal to the first switch, wherein the first switch and the decoupling signal are configured such that the first switch electrically decouples the first pole from the ground potential upon receiving the first decoupling signal. The first decoupling signal may be generated by the controller and may be sent to the first switch by the controller. Alternatively, when the first switch is already electrically decoupled to the ground potential, the first decoupling signal does not have to be sent to the first switch.

The second pole may be a negative pole of the battery pack, for example. The second pole may be electrically coupled to the ground potential by sending a second coupling signal to the second switch, wherein the second switch and the second coupling signal are configured such that the second switch electrically couples the second pole to the ground potential upon receiving the second coupling signal. The second coupling signal may be generated by the controller and may be sent to the second switch by the controller. Alternatively, when the second switch is already electrically coupled to the ground potential, the second coupling signal does not have to be sent to the second switch.

The second pole may be electrically decoupled from the ground potential by sending a second decoupling signal to the second switch, wherein the second switch and the decoupling signal are configured such that the second switch electrically decouples the second pole from the ground potential upon receiving the second decoupling signal. The second decoupling signal may be generated by the controller and may be sent to the second switch by the controller. Alternatively, when the second switch is already electrically decoupled from the ground potential, the second decoupling signal does not have to be sent to the second switch.

The voltages each may be measured by the at least one voltmeter or by two different voltmeters. The voltmeters may be components of the battery arrangement or of a Battery Management System (BMS) for controlling the battery arrangement. The voltages may be measured by the voltmeters by sending a corresponding measurement signal to the corresponding voltmeter, e.g., by the controller, and by receiving corresponding voltage signals from the corresponding voltmeter, e.g., by the controller, wherein the corresponding voltmeter generates the corresponding voltage signals depending on the correspondingly measured voltages.

That one of the voltage values is representative of the corresponding measured voltage may mean that the measured voltage can be derived from the corresponding voltage value. For example, the voltage value may be proportional to the corresponding measured voltage, wherein the corresponding proportional factor is known. Alternatively or additionally, one or more resistors may be present between a position at which the voltage is measured and the position to which the corresponding voltage value refers. However, because these resistors are known in advance, the voltage value can easily be derived from the corresponding measured voltage.

That one of the above-mentioned voltage values "at least approaches zero" may mean that the corresponding voltage value is zero or is approximately zero and slims to none. That a voltage value is "approximately zero" may mean in this context that sensor voltage is smaller than 0.5V or ¼ of the battery voltage. Correspondingly, that the first or the second voltage values approximately correspond to the battery voltage may mean that sensor voltage is smaller than 0.5V or ¼ of the battery voltage. That the first voltage value and the second voltage value are "well between zero and the battery voltage" may mean that neither the first nor the second voltage value approach zero or are approximately zero, and that neither the first nor the second voltage value approximately correspond to the battery voltage.

The battery voltage refers to the total battery voltage of the battery pack in the earth-fault-free condition and in earth fault condition. The battery voltage may be given in advance, in other words, the battery voltage may be predetermined. In particular, in the most cases, an entity carrying out the method, e.g., the controller and/or a corresponding BMS, "knows" the total battery voltage of the battery pack in advance. For example, the total battery voltage of the battery pack may be stored in the memory of the controller. Alternatively, the total battery voltage may be calculated by adding the first voltage value to the second voltage value. Alternatively, the total battery voltage may be measured as a third voltage value, as explained below.

The first and second resistors may be arranged for determining the voltage values between the poles and the ground potential. The first and second resistors each may have a resistance in a range from 5 kΩ to 50 kΩ, e.g., from 10 kΩ to 30kΩ, e.g., approximately 20kΩ. The first switch may be coupled to the battery pack via a third resistor. The third resistor may have a resistance in a range from 1 MEGΩ to 10 MEGΩ, e.g., about 5 MEGΩ. Optionally, the third resistor may be coupled to the first resistor via a fourth resistor, wherein the fourth resistor may have a very high resistance, e.g. greater than 100 MEGΩ. In case of omitting the fourth resistor, its resistance may be assumed as being infinite. The second switch may be coupled to the battery pack via a fifth resistor. The fifth resistor may have a resistance in a range from 1 MEGΩ to 1 MEGΩ, e.g., about 5 MEGΩ. Optionally, the fifth resistor may be coupled to the second resistor via a sixth resistor, wherein the sixth resistor may have a very high resistance, e.g., greater than 100 MEGΩ. In case of omitting the sixth resistor, its resistance may be assumed as being infinite. The third and fifth resistors may be arranged for being loaded when the corresponding switch is closed and for provoking an earth-fault current in case of the earth-fault being present. The fourth and sixth resistors may be arranged for discharging parasitic capacitors within the battery pack.

The controller may be referred to as BMS or may be a component of the BMS. The BMS may be configured for operating the battery arrangement. The controller may be referred to as Insulation Monitoring Device or may be a component of the IMD. In the latter case, the IMD may be a component of the BMS.

The battery arrangement may be configured for providing electric energy to a load. The load may be an electric motor, e.g., a motor for driving an electric vehicle. The electric vehicle may be configured for transporting one or more persons and/or goods. The electric vehicle may be an on-road or an off-road vehicle, e.g., a mining truck, a train, a tram, or a subway. In this context, the battery pack may be a component of an energy storage system of the electric vehicle and may be referred to as propulsion battery pack of the electric vehicle.

In case of the battery pack being in the earth-fault-free condition, the energy storage system, in particular the battery pack, may be operated normally. For example, in case of the energy storage system providing the propulsion energy to the electric vehicle, the energy storage system and in particular the battery pack may be used for providing the propulsion energy for the electric vehicle. In contrast, in case of the earth-fault being present, a safety measure may be initiated, e.g., by the controller. The safety measure may comprise or may be one or more safety measures out of a group of safety measures, the group comprising: deactivating the energy storage system, deactivating the battery arrangement and/or battery pack, and/or sending a warning signal to an operator of the energy storage system, e.g., of the vehicle.

According to an embodiment, the method comprises: determining that the battery arrangement is in an earth-fault-free condition, when the first voltage value and the second voltage value each at least approach zero.

According to an embodiment, wherein, when determining the exact location of the earth-fault between the first and second poles depending on the ratio the ratio is determined by V1/(V1+V2), and/or by 1-(V2/(V1+V2)). In this case, the earth-fault is determined as being the closer to the first pole the smaller the ratio is, and the earth-fault is determined as being the closer to the second pole the larger the ratio is. For example, when the earth-fault is exactly in the middle of the battery pack, the first and second voltage values are at least approximately the same and the ratio is at least approximately 0.5. In contrast, when the earth-fault is closer to the first terminal, the ratio is smaller than 0.5 and, when the earth-fault is closer to the second terminal, the ratio is larger than 0.5. For example, when the ratio is smaller than 0.1 the earth-fault is close to first terminal, whereas the earth-fault is close to second terminal when the ratio is larger than 0.9. As one further example, in case of the battery pack having n battery cells, with n being a natural number and with the battery cells being numbered from 1 to n, the earth-fault is at least close to the battery cell having the number n/4 when the ratio is 0.25.

According to an embodiment, after electrically coupling the second pole to the ground potential by the second switch and before electrically decoupling the first pole from the ground potential by the first switch, the method comprises: measuring a third voltage over the battery arrangement, wherein a corresponding third voltage value corresponds to the battery voltage. In particular, the third voltage value may correspond to the given value of the battery voltage. The third voltage should always be measured when the first and second switches are closed. Therefore and because of the possibility to measure the second voltage before the first voltage, the third voltage may be measured after electrically coupling the first pole to the ground potential by the first switch and before electrically decoupling the second pole from the ground potential by the second switch, when the second voltage is measured before the first voltage.

According to an embodiment, the method comprises: determining a first preliminary resistance of the earth-fault from the first voltage value; determining a second preliminary resistance of the earth-fault from the second voltage value; and determining a final resistance of the earth-fault from the first and second preliminary resistances.

According to an embodiment, the final resistance is determined from the first and second preliminary resistances by calculating an average between the first and second resistances, wherein the final resistance corresponds to the determined average.

According to an embodiment, while the first and second poles are electrically decoupled from the ground potential by the corresponding switch, the method comprises: measuring a diagnose voltage over the battery pack; and determining depending on the diagnose voltage whether the earth-fault can be validly localized or whether the localization of the earth-fault is valid. When the order in which the steps are carried out corresponds to the order in which the steps are specified by claim 1, the first and second poles may be electrically decoupled from the ground potential before electrically coupling the first pole to the ground potential, or after measuring the second voltage and after electrically decoupling the second pole from the ground potential. In contrast, when the second voltage is measured before the first voltage, the first and second poles may be electrically decoupled from the ground potential before electrically coupling the second pole to the ground potential, or after measuring the first voltage and after electrically decoupling the first pole from the ground potential. In any case, the diagnose voltage may be measured before and/or after measuring the first or second voltages. When the diagnose voltage is measured before measuring the first or second voltages, it may be determined depending on the diagnose voltage whether the earth-fault can be validly localized afterwards. When the diagnose voltage is measured after measuring the first or second voltages, it may be determined depending on the diagnose voltage whether the localization of the earth-fault is valid.

According to an embodiment, the earth-fault can be validly localized, when the diagnose voltage at least approximately corresponds to the ground potential.

According to an embodiment, the localization of the earth-fault is determined as being valid, when the diagnose voltage at least approximately corresponds to the ground potential.

These and other aspects of the invention will be apparent from and elucidated with reference to the embodiments described hereinafter.

BRIEF DESCRIPTION OF THE DRAWINGS

The subject matter of the invention will be explained in more detail in the following text with reference to exemplary embodiments which are illustrated in the attached drawings.

Fig. 1 shows a block diagram of an exemplary embodiment of a battery arrangement;

Fig. 2 shows an example of a first diagram showing different voltage values measured within the battery arrangement in an earth-fault-free condition of the battery arrangement;

Fig. 3 shows an example of a second diagram showing the different voltage values measured within the battery arrangement when an earth-fault is present at a first pole of a battery pack of the battery arrangement;

Fig. 4 shows an example of a third diagram showing the different voltage values measured within the battery arrangement when an earth-fault is present at a second pole of the battery pack of the battery arrangement;

Fig. 5 shows an example of a fourth diagram showing the different voltage values measured within the battery arrangement when an earth-fault is present between the first and second poles of the battery pack of the battery arrangement.

Fig. 6 shows a flow-diagram of an exemplary embodiment of a method for localizing the earth-fault within the battery arrangement.

The reference symbols used in the drawings, and their meanings, are listed in summary form in the list of reference symbols. In principle, identical parts are provided with the same reference symbols in the figures.

DETAILED DESCRIPTION OF EXEMPLARY EMBODIMENTS

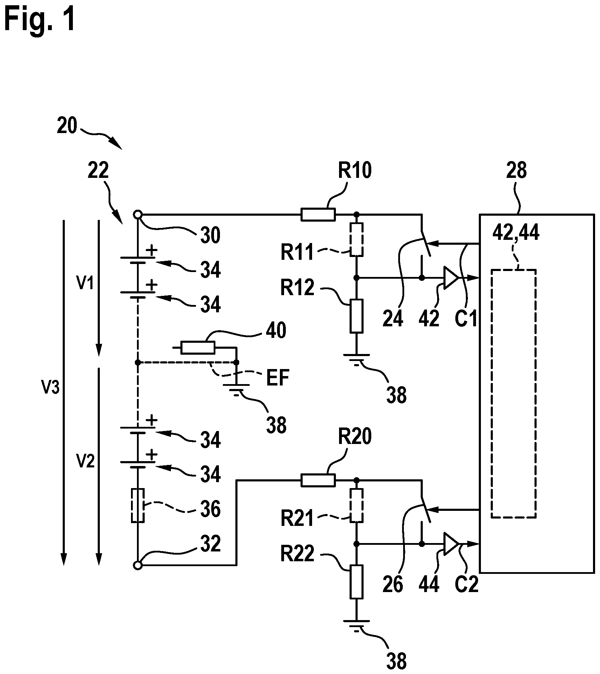

Fig. 1 shows a block diagram of an exemplary embodiment of a battery arrangement 20. The battery arrangement 20 may be configured for providing electric energy to a load (not shown). The load may be an electric motor, e.g., a motor for driving an electric vehicle (not shown). The electric vehicle may be configured for transporting one or more persons and/or goods. The electric vehicle may be an on-road or an off-road vehicle, e.g., a mining truck, a train, a tram, or a subway. In this context, the battery arrangement 20 may be a component of an energy storage system of the electric vehicle and may be referred to as propulsion battery arrangement of the electric vehicle.

The battery arrangement 20 comprises at least one battery pack 22, a first switch 24, a second switch 26, and a controller 28. The battery pack 22 comprises a first pole 30, e.g., a positive pole, a second pole 32, e.g., a negative pole, and at least two battery cells 34 electrically arranged in series between the first pole 30 and the second pole 32. The first switch 24 is electrically arranged between the first pole 30 and a first resistor R12. The first resistor R12 electrically couples the first switch 24 to the ground potential 38. The second switch 26 is electrically arranged between the second pole 32 and a second resistor R22. The second resistor R22 electrically couples the second switch 26 to the ground potential 38. The first and second resistors R12, R22 may be arranged for determining different voltage values V1, V2, V3 determined by measuring corresponding voltages between the poles 30, 32 and the ground potential 38. The first and second resistors R12, R22 each may have a resistance in a range from 5 k$\Omega$ to 50 k$\Omega$, e.g., from 10 k$\Omega$ to 30k$\Omega$, e.g., approximately 20k$\Omega$.

The first switch 24 may be coupled to the battery pack 20 via a third resistor R10. The third resistor R10 may have a resistance in a range from 1 MEG$\Omega$ to 10 MEG$\Omega$, e.g., about 5 MEG$\Omega$. Optionally, the third resistor R10 may be coupled to the first resistor R12 via a fourth resistor R11, wherein the fourth resistor R11 may have a very high resistance, e.g., greater than 100 M$\Omega$. The second switch 26 may be coupled to the battery pack 22 via a fifth resistor R20. The fifth resistor R20 may have a resistance in a range from 1 MEG$\Omega$ to 10 MEG$\Omega$, e.g., about 5 MEG$\Omega$. Optionally, the fifth resistor R20 may be coupled to the second resistor R12 via a sixth resistor R21, wherein the sixth resistor R21 may have a very high resistance, e.g., greater than 100 M$\Omega$. The third and fifth resistors R10, R20 may be arranged for being loaded when the corresponding switch 24, 26 is closed and for provoking an earth-fault current in case of an earth-fault EF being present. The fourth and sixth resistors R11, R21 may be arranged for discharging parasitic capacitors within the battery pack 22.

In case of the battery arrangement 20, in particular the battery pack 22, being in an earth-fault free condition, an insulation resistance 40 of an electric insulation of the battery pack 22 is present between the battery pack 22 and the ground potential 38. In contrast, in case of the earth-fault EF being present, the insulation of the battery pack 22 may be damaged and the insulation resistance 40 of the insulation may be bypassed by the earth-fault EF. In the exemplary embodiment shown in figure 1, the earth-fault EF is depicted as being present in the middle of the battery pack 22. However, the earth-fault EF may be present at the first or second poles 30, 32 or anywhere between the first and second poles 30, 32.

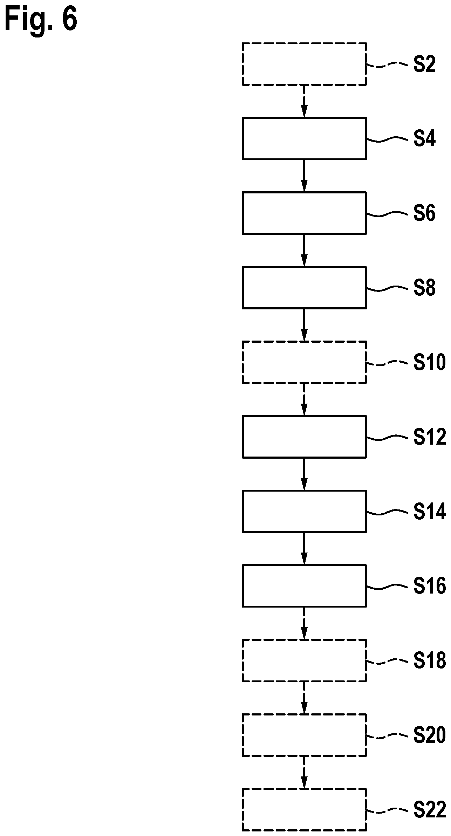

The controller 28 comprises at least one voltmeter, e.g., a first voltmeter 42 and a second voltmeter 44, a memory, and a processor (not shown). The controller 28 is communicatively coupled to the first switch 24 and to the second switch 26 for controlling, in particular closing or opening, the corresponding switch 24, 26. The memory is configured for storing one or more voltage values V1, V2, V3 of the measured voltages. The processor may be communicatively coupled to the memory. The controller 28 is configured for localizing the earth-fault EF within the battery arrangement 20. In particular, the controller 28, e.g., the processor of the controller 28, may be configured to carry out a method for localizing the earth-fault EF within the battery arrangement 20 based on the measured voltage values V1, V2, V3, as explained with respect to figure 6. The controller 28 may be a BMS or may be a component of the BMS. The BMS may be configured for operating the battery arrangement 20. The controller 28 may be referred to as Insulation Monitoring Device (IMD) or may be a component of the IMD. In the latter case, the IMD may be a component of the BMS.

A first voltage value V1 of the voltage values V1, V2, V3 may be measured by the first voltmeter 42. A second voltage value V2 of the voltage values V1, V2, V3 may be measured by the second voltmeter 44. A third voltage value V3 of the voltage values V1, V2, V3 may be measured by the first or second voltmeter 42, 44. In an optional embodiment, in which the first and second voltmeters 42, 44 are substituted by one single voltmeter 42, 44 (see figure 1, dashed lines), the first to third voltages values V1, V2, V3 may be measured by this one single voltmeter. In any case, each of the voltmeters 42, 44 is internally coupled to the ground potential 38 (not shown in the figures) and the corresponding voltage is measured against or relative the ground potential 38.

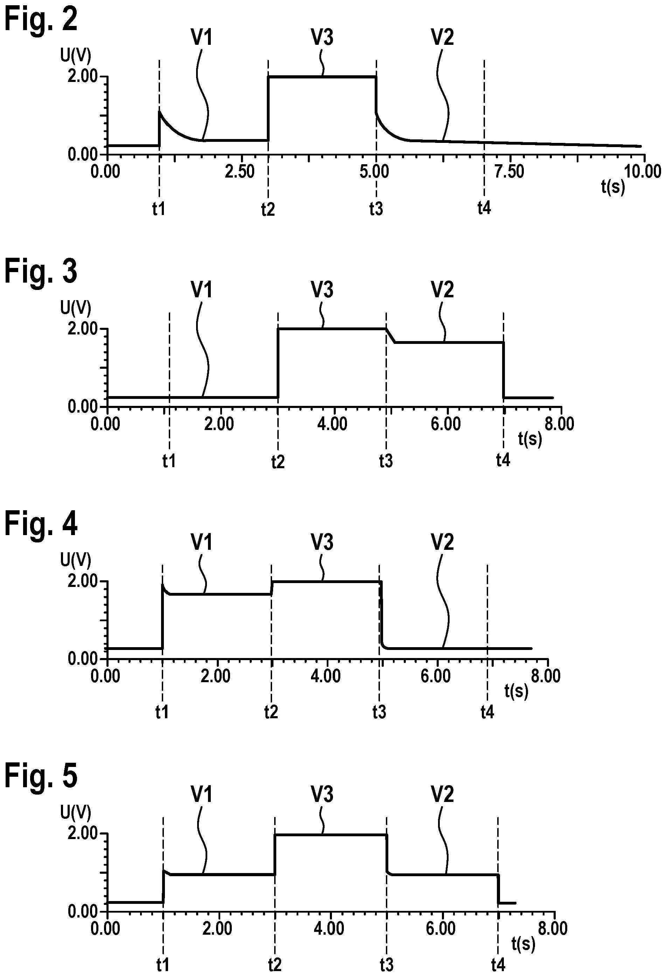

The voltmeter(s) 42, 44 may be a component of the battery arrangement 20 or of a Battery Management System (BMS) for controlling the battery arrangement 20. The voltage values V1, V2, V3 may be measured by the voltmeter(s) 42 by sending a measurement signal to the corresponding voltmeter 42, 44, e.g., by the controller 28, and by receiving corresponding voltage signals from the corresponding voltmeter 42, 44, e.g., by the controller 28, wherein the voltmeter(s) 42 generate(s) the voltage signals depending on the measured voltage values V1, V2, V3. The values of the voltages V1, V2, V3 are representative of whether the earth-fault EF is present within the battery arrangement 20 and in particular where in the battery arrangement the earth-fault EF exactly is, as explained with respect to figures 2 to 5.

The first pole 30 may be electrically coupled to the ground potential 38 by sending a first coupling signal to the first switch 24. The first switch 24 and the coupling signal may be configured such that the first switch 24 electrically couples the first pole 30 to the ground potential 38 upon receiving the first coupling signal. The first coupling signal may be generated by the controller 28 and may be sent to the first switch 24 by the controller 28. Alternatively, when the first switch 24 is already electrically coupled to the ground potential 38, the first coupling signal does not have to be sent to the first switch 24.

The first pole 30 may be electrically decoupled from the ground potential 38 by sending a first decoupling signal to the first switch 24, wherein the first switch 24 and the first decoupling signal are configured such that the first switch 24 electrically decouples the first pole 30 from the ground potential 38 upon receiving the first decoupling signal. The first decoupling signal may be generated by the controller 28 and may be sent to the first switch 24 by the controller 28. Alternatively, when the first switch 24 is already electrically decoupled to the ground potential 38, the first decoupling signal does not have to be sent to the first switch 24.

The second pole 32 may be a negative pole of the battery pack 22, for example. The second pole 32 may be electrically coupled to the ground potential 38 by sending a second coupling signal to the second switch 26. The second switch 26 and the second coupling signal may be configured such that the second switch 26 electrically couples the second pole 32 to the ground potential 38 upon receiving the second coupling signal. The second coupling signal may be generated by the controller 28 and may be sent to the second switch 26 by the controller 28. Alternatively, when the second switch 26 is already electrically coupled to the ground potential 38, the second coupling signal does not have to be sent to the second switch 26.

The second pole 32 may be electrically decoupled from the ground potential 38 by sending a second decoupling signal to the second switch 26, wherein the second switch 26 and the decoupling signal are configured such that the second switch 26 electrically decouples the second pole 32 from the ground potential 38 upon receiving the second decoupling signal. The second decoupling signal may be generated by the controller 28 and may be sent to the second switch 26 by the controller 28. Alternatively, when the second switch 26 is already electrically decoupled from the ground potential 38, the second decoupling signal does not have to be sent to the second switch 26.

Fig. 2 shows an example of a first diagram showing the different voltage values V1, V2, V3 measured within the battery arrangement 20 in an earth-fault-free condition of the battery arrangement 20.

At the beginning of the measurement, the first and second switches 24, 26 are open and thereby the poles 30, 32 are electrically decoupled from the ground potential 38 by the corresponding switch 24, 26. In this case, a diagnose voltage may be measured, e.g., by the voltmeter 42. The diagnose voltage measured before a first point in time t1 may be referred to as first diagnose voltage. The localization of the earth-fault EF may be validly started, when the first diagnose voltage is at least approximately zero, e.g., zero.

At the first point in time t1, the first pole 30 is electrically coupled to the ground potential 38 by the first switch 24. The first voltage value V1 captured by measuring the first voltage between the first point in time t1 and a second point in time t2 shortly rises when closing the first switch 24 because of parasitic capacitances within the battery arrangement 20, but then drops to approximately zero, e.g., to zero.

At the second point in time t2, the second pole 32 is electrically coupled to the ground potential 38 by the second switch 26. The third voltage value V3 captured by measuring the third voltage between the second point in time t2 and a third point in time t3 raises quickly to the battery voltage of the battery arrangement 20, in particular of the battery pack 22. In other words, the third voltage value V3 at least approximately corresponds to the overall battery voltage of the battery pack 22.

At the third point in time t3, the first pole 30 is electrically decoupled from the ground potential 38 by the first switch 24. The second voltage value V2 captured by measuring the second voltage between the third point in time t3 and a fourth point in time t4 drops to approximately zero, e.g., to zero.

At the fourth point in time t4, the second pole 32 is electrically decoupled from the ground potential 38 by the second switch 26 such that the first and second switches 24, 26 are open and thereby the poles 30, 32 are electrically decoupled from the ground potential 38 by the corresponding switch 24, 26. In this case, another diagnose voltage may be measured, e.g., by the voltmeter 42. The diagnose voltage measured after the fourth point in time t4 may be referred to as second diagnose voltage. The localization of the earth-fault EF may be considered as being valid, when the second diagnose voltage drops to at least approximately zero, e.g., to zero.

Fig. 3 shows an example of a second diagram showing the different voltage values V1, V2, V3 measured within the battery arrangement 20 when the earth-fault EF is present at the first pole 30 of the battery pack 22 of the battery arrangement 20.

At the beginning of the measurement, the first and second switches 24, 26 are open and thereby the poles 30, 32 are electrically decoupled from the ground potential 38 by the corresponding switch 24, 26. The first diagnose voltage may be measured before the first point in time 11. The localization of the earth-fault EF may be validly started, when the first diagnose voltage is at least approximately zero, e.g., zero.

At the first point in time t1, the first pole 30 is electrically coupled to the ground potential 38 by the first switch 24. The first voltage value V1 measured between the first point in time t1 and a second point in time t2 stays at least approximately at zero, e.g., at zero, because of the earth- fault EF at the first pole 30.

At the second point in time t2, the second pole 32 is electrically coupled to the ground potential 38 by the second switch 26. The third voltage value V3 measured between the second point in time t2 and a third point in time t3 raises quickly to the battery voltage of the battery arrangement 20, in particular of the battery pack 22.

At the third point in time t3, the first pole 30 is electrically decoupled from the ground potential 38 by the first switch 24. The second voltage value V2 measured between the third point in time t3 and a fourth point in time t4 drops only a little bit but stays at least approximately at the battery voltage, e.g., at the battery voltage.

At the fourth point in time t4, the second pole 32 is electrically decoupled from the ground potential 38 by the second switch 26 such that the first and second switches 24, 26 are open and thereby the poles 30, 32 are electrically decoupled from the ground potential 38 by the corresponding switch 24, 26. Then, the second diagnose voltage may be measured. The localization of the earth-fault EF may be considered as being valid, when the second diagnose voltage drops to at least approximately zero, e.g., to zero.

Fig. 4 shows an example of a third diagram showing the different voltage values V1, V2, V3 measured within the battery arrangement 20 when the earth-fault EF is present at the second pole 32 of the battery pack 22 of the battery arrangement 20.

At the beginning of the measurement, the first and second switches 24, 26 are open and thereby the poles 30, 32 are electrically decoupled from the ground potential 38 by the corresponding switch 24, 26. The first diagnose voltage may be measured before the first point in time 11. The localization of the earth-fault EF may be validly started, when the first diagnose voltage is at least approximately zero, e.g., zero.

At the first point in time t1, the first pole 30 is electrically coupled to the ground potential 38 by the first switch 24. The first voltage value V1 measured between the first point in time t1 and a second point in time t2 raises to at least approximately the battery voltage, e.g., to the battery voltage.

At the second point in time t2, the second pole 32 is electrically coupled to the ground potential 38 by the second switch 26. The third voltage value V3 measured between the second point in time t2 and a third point in time t3 raises to the battery voltage of the battery arrangement 20, in particular of the battery pack 22.

At the third point in time t3, the first pole 30 is electrically decoupled from the ground potential 38 by the first switch 24. The second voltage value V2 measured between the third point in time t3 and the fourth point in time t4 drops at least approximately to zero, e.g., to zero, because of the earth-fault at the second pole 32.

At the fourth point in time t4, the second pole 32 is electrically decoupled from the ground potential 38 by the second switch 26 such that the first and second switches 24, 26 are open and thereby the poles 30, 32 are electrically decoupled from the ground potential 38 by the corresponding switch 24, 26. Then, the second diagnose voltage may be measured. The localization of the earth-fault may be considered as being valid, when the second diagnose voltage is at least approximately zero, e.g., zero.

Fig. 5 shows an example of a fourth diagram showing the different voltage values V1, V2, V3 measured within the battery arrangement 20 when an earth-fault EF is present between the first and second poles 30, 32 of the battery pack 22 of the battery arrangement 20, in particular at the middle of the battery pack 22.

At the beginning of the measurement, the first and second switches 24, 26 are open and thereby the poles 30, 32 are electrically decoupled from the ground potential 38 by the corresponding switch 24, 26. The first diagnose voltage may be measured before the first point in time 11. The localization of the earth-fault EF may be validly started, when the first diagnose voltage is at least approximately zero, e.g., zero.

At the first point in time t1, the first pole 30 is electrically coupled to the ground potential 38 by the first switch 24. The first voltage value V1 measured between the first point in time t1 and a second point in time t2 raises to at least approximately the half of the battery voltage, e.g., to the half of the battery voltage, because of the earth-fault EF being present in the middle of the battery pack 22.

At the second point in time t2, the second pole 32 is electrically coupled to the ground potential 38 by the second switch 26. The third voltage value V3 measured between the second point in time t2 and a third point in time t3 raises to the battery voltage of the battery arrangement 20, in particular of the battery pack 22.

At the third point in time t3, the first pole 30 is electrically decoupled from the ground potential 38 by the first switch 24. The second voltage value V2 measured between the third point in time t3 and the fourth point in time t4 drops at least approximately to the half of the battery voltage, e.g., to the half of the battery voltage, because of the earth-fault EF being present in the middle of the battery pack 22.

At the fourth point in time t4, the second pole 32 is electrically decoupled from the ground potential 38 by the second switch 26 such that the first and second switches 24, 26 are open and thereby the poles 30, 32 are electrically decoupled from the ground potential 38 by the corresponding switch 24, 26. Then, the second diagnose voltage may be measured. The localization of the earth-fault EF may be considered as being valid, when the second diagnose voltage is at least approximately zero, e.g., zero.

Fig. 6 shows a flow-diagram of an exemplary embodiment of the method for localizing the earth-fault EF within the battery arrangement 20. The method may be carried out by the controller 28. The first and second poles 30, 32 may be electrically decoupled from the ground potential 38 by the corresponding switch 24, 26 when the method is started.

In an optional step S2, the diagnose voltage, in particular the first diagnose voltage, over the battery pack may be measured. Then, it may be determined whether the localization of the earth-fault can be validly determined depending on the first diagnose voltage. In particular, it may be determined that the localization of the earth-fault EF can be validly determined, when the first diagnose voltage at least approximately corresponds to the ground potential 38.

In a step S4, the first pole 30 may be electrically coupled to the ground potential 38 by the first switch 24, while the second pole 32 stays electrically decoupled from the ground potential 38 by the second switch 26.

In a step S6, the first voltage value V1 may be measured between the first switch 24 and the ground potential 38.

In a step S8, the second pole 32 may be electrically coupled to the ground potential 38 by the second switch 26.

In an optional step S10, the third voltage value V3 may be measured over the battery pack 22. The third voltage value V3 may correspond to the battery voltage. In particular, the third voltage value V3 may correspond to the given battery voltage. The third voltage value V3 should always be measured when the first and second switches 24, 26 are closed.

In a step S12, the first pole 30 may be electrically decoupled from the ground potential 38 by the first switch 24.

In a step S14, the second voltage value V2 may be measured between the first switch 24 and the ground potential 38.

In a step S16, it may be determined that the earth-fault EF is present at the first pole 30, when the first voltage value V1 at least approaches zero and the second voltage value V2 at least approximately corresponds to the given battery voltage of the battery pack 22, as depicted in figure 3.

Alternatively, it may be determined in step S16 that the earth-fault EF is present at the second pole 32, when the second voltage value V2 at least approaches zero and the first voltage value V1 at least approximately corresponds to the battery voltage, as depicted in figure 4.

Alternatively, it may be determined in step S16 that the earth-fault EF is present between the first and second poles 30, 32, when the first voltage value V1 and the second voltage value V2 are well between zero and the battery voltage, wherein an exact location of the earth-fault EF between the first and second poles 30, 32 may be determined depending on a ratio determined from the first voltage value V1 and the second voltage value V2.

The ratio may be determined by adding the first voltage value V1 to the second voltage value V2 and by dividing the first voltage value V1 through the sum of the first voltage value V1 to the second voltage value V2, i.e., V1/(V1+V2). Alternatively or additionally, the ratio may be determined by dividing the second voltage value V2 through the sum of the first voltage value V1 to the second voltage value V2 and by subtracting the result from 1, i.e., 1-(V2/(V1+V2)). In this case, when determining the exact location of the earth-fault EF between the first and second poles 30, 32 depending on the ratio, the earth-fault EF is determined as being the closer to the first pole 30 the smaller the ratio is, and the earth-fault EF is determined as being the closer to the second pole 32 the larger the ratio is. For example, as depicted in figure 5 the earth-fault EF may be in the middle of the battery pack 22 when the first and second voltages V1, V2 are at least approximately the same and the ratio is at least approximately 0.5. The ratio is smaller than 0.5 when the earth-fault EF is closer to the first terminal 30, and the ratio is larger than 0.5, when the earth-fault EF is closer to the second terminal 32. For example, when the ratio is smaller than 0.1 the earth-fault is close to first terminal 30, whereas the earth-fault is close to second terminal 32 when the ratio is larger than 0.9. As one further example, in case of the battery pack 22 having n battery cells, with n being a natural number and with the battery cells being numbered from 1 to n, the earth-fault is at least close to the battery cell having the number n/4 when the ratio is 0.25.

As pointed out above, the ratio may be determined in two different ways, in particular by two different formulas. Basically, both ways can be used on their own and independent from the other way. However, when the earth-fault is close to the first pole 30, the first voltage value V1 is very small and the ratio determined by the first one of the above formulas may be relatively coarse. However, in this case, the ratio determined by the second one of the above formulas may be relatively precise. Similarly, when the earth-fault is close to the second pole 32, the second voltage value V2 is very small and the ratio determined by the second one of the above formulas may be relatively coarse. However, in this case, the ratio determined by the first one of the above formulas may be relatively precise. Therefore, it may be advantageous to determine the ratio by both formulas always. In this case, the determination of the ratio may be very precise independent therefrom where the earth-fault is.

In contrast, it may be determined in step S16 that the battery arrangement 20 is in an earth-fault-free condition, when the first voltage V1 and the second voltage V2 each at least approach zero, as depicted in figure 2.

In an optional step S 18, the second pole 32 may be electrically decoupled from the ground potential 38 by the second switch 26 and a second diagnose voltage over the battery pack may be measured. In this case, it may be determined whether the localization of the earth-fault EF is valid depending on the second diagnose voltage. In particular, the localization of the earth-fault EF may be determined as being valid, when the second diagnose voltage at least approximately corresponds to the battery voltage of the battery arrangement 20.

In an optional step S20, a safety measure may be initiated, e.g., by the controller 28, when the earth-fault EF is determined as being present, and, in case of the optional step S18 having been carried out, when the localization of the earth-fault EF was determined as being valid. The safety measure may comprise or may be one or more safety measures out of a group of safety measures, the group comprising: deactivating the energy storage system, deactivating the battery arrangement 20 and/or battery pack 22, and/or sending a warning signal to an operator of the energy storage system, e.g., of the vehicle.

Alternatively, in case of the battery pack 22 having been determined as being in the earth-fault-free condition, the energy storage system, in particular the battery pack 22, may be operated normally, e.g., in step S20. For example, in case of the energy storage system providing the propulsion energy to the electric vehicle, the energy storage system and in particular the battery pack 22 may be used for providing the propulsion energy for the electric vehicle.

In an optional step S22, a first preliminary resistance of the earth-fault EF may be determined from the first voltage V1, a second preliminary resistance of the earth-fault EF may be determined from the second voltage V2; and determining a final resistance of the earth-fault from the first and second preliminary resistances. The final resistance may be determined as an average between the first and second preliminary resistances.

The order of the steps of the above method may be altered. In particular, the first voltage value V1 should always be measured when the first switch 24 is closed and the second switch 26 is open, and the second voltage value V2 should always be measured when the second switch 26 is closed and the first switch is open 24. However, the second voltage value V2 may be measured before measuring the first voltage value V1. In addition, the order of the determining whether the earth-fault is present at the first pole 30, the second pole 32, or between the first and second poles 30, 32 may also be altered.

The method may be embodied as a computer program for localizing the earth-fault EF within the battery arrangement 20. The computer program comprises computer-readable instructions, which, when being carried out by the processor of the controller 28, cause the controller 28 to carry out the method as described above. The computer program may be stored on a computer-readable medium. The computer-readable medium may be a floppy disk, a hard disk, an USB storage device, a RAM, a ROM, an EPROM or a FLASH memory. The computer readable medium may also be a data communication network, e.g. the Internet, which allows downloading a program code. In general, the computer-readable medium may be a non-transitory or transitory medium.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

LIST OF REFERENCE SYMBOLS

| Battery arrangement | 20 |
| Battery pack | 22 |
| First switch | 24 |
| Second switch | 26 |
| Controller | 28 |
| First pole | 30 |
| Second pole | 32 |
| Battery cell | 34 |
| Fuse | 36 |
| Ground potential | 38 |

| Insulation resistance | 40 |
| First voltmeter | 42 |
| Second voltmeter | 44 |
| First voltage | V1 |
| Second voltage | V2 |
| Third voltage | V3 |
| First resistor | R12 |
| Second resistor | R22 |
| Third resistor | R10 |
| Fourth resistor | R11 |
| Fifth resistor | R20 |
| Sixth resistor | R21 |
| Points in time | t1, t2, t3, t4 |
| Earth-fault | EF |

**Claims**

1. A method for localizing an earth-fault (EF) within a battery arrangement (20), the battery arrangement (20) comprising a battery pack (22) having a first pole (30), a second pole (32), and at least two battery cells (34) electrically arranged in series between the first pole (30) and the second pole (32), and a first switch (24) electrically arranged between the first pole (30) and a first resistor (R12), with the first resistor (R12) electrically coupling the first switch (24) to a ground potential (38), and a second switch (26) electrically arranged between the second pole (32) and a second resistor (R22), with the second resistor (R22) electrically coupling the second switch (26) to the ground potential (38), the method comprising:

   electrically coupling the first pole (30) to the ground potential (38) by the first switch (24), while the second pole (32) is electrically decoupled from the ground potential (38) by the second switch (26);
   measuring a first voltage between the first switch (24) and the ground potential (38);
   determining a first voltage value (V1) depending on the measured first voltage, wherein the first voltage value (V1) is representative of the measured first voltage;
   electrically coupling the second pole (32) to the ground potential (38) by the second switch (26);
   electrically decoupling the first pole (30) from the ground potential (38) by the first switch (24);
   measuring a second voltage between the second switch (26) and the ground potential (38)
   determining a second voltage value (V2) depending on the measured second voltage wherein the second voltage value (V2) is representative of the measured second voltage;
   determining that an earth-fault (EF) is present at the first pole (30), when the first voltage value (V1) at least approaches zero and the second voltage value (V2) at least approximately corresponds to a given battery voltage of the battery pack (22);
   determining that an earth-fault (EF) is present at the second pole (32), when the second voltage value (V2) at least approaches zero and the first voltage value (V1) at least approximately corresponds to the battery voltage; and
   determining that an earth-fault (EF) is present between the first and second poles (30, 32), when the first voltage value (V1) and the second voltage value (V2) are well between zero and the battery voltage, wherein an exact location of the earth-fault (EF) between the first and second poles (30, 32) is determined depending on a ratio determined from the first voltage value (V1) and the second voltage value (V2).

2. The method according to claim 1, comprising:
   determining that the battery arrangement (20) is in an earth-fault-free condition, when the first voltage value (V1) and the second voltage value (V2) each at least approach zero.

3. The method according to one of the preceding claims, wherein
   when determining the exact location of the earth-fault between the first and second poles depending on the ratio, the ratio is determined by

$$V1/(V1+V2),$$

   and/or by

$$1-(V2/(V1+V2))$$

4. The method according to one of the preceding claims, after electrically coupling the second pole (32) to the ground potential (38) by the second switch (26) and before electrically decoupling the first pole (30) from the ground potential (38) by the first switch (24), comprising:
measuring a third voltage over the battery arrangement (20), wherein a corresponding third voltage value (V3) corresponds to the battery voltage.

5. The method according to one of the preceding claims, comprising:

determining a first preliminary resistance of the earth-fault (EF) from the first voltage value (V1);
determining a second preliminary resistance of the earth-fault (EF) from the second voltage value (V2); and
determining a final resistance of the earth-fault (EF) from the first and second preliminary resistances.

6. The method according to claim 5, wherein
the final resistance is determined from the first and second preliminary resistances by calculating an average between the first and second resistances, wherein the final resistance corresponds to the determined average.

7. The method in accordance with one of the preceding claims, while the first and second poles (30, 32) are electrically decoupled from the ground potential (38) by the corresponding switch (24, 26), the method comprising:

measuring a diagnose voltage over the battery pack (22); and
determining depending on the diagnose voltage whether the earth-fault (EF) can be validly localized or whether the localization of the earth-fault (EF) is valid.

8. The method in accordance with claim 7, wherein
the earth-fault (EF) can be validly localized, when the diagnose voltage at least approximately corresponds to the ground potential (38).

9. The method in accordance with claim 7, wherein
the localization of the earth-fault (EF) is determined as being valid, when the diagnose voltage at least approximately corresponds to the ground potential (38).

10. Controller (28) for localizing an earth-fault (EF) within a battery arrangement (20), the battery arrangement (20) comprising a battery pack (22) having a first pole (30), a second pole (32), and at least two battery cells (34) electrically arranged in series between the first pole (30) and the second pole (32), and a first switch (24) electrically arranged between the first pole (30) and a first resistor (R12), with the first resistor (R12) electrically coupling the first switch (24) to a ground potential (38), and a second switch (26) electrically arranged between the second pole (32) and a second resistor (R22), with the second resistor (R22) electrically coupling the second switch (26) to the ground potential (38), the controller (28) comprising:

at least one voltmeter (42, 44) being arranged and configured to measure at least a first voltage between the first switch (24) and the ground potential (38) and a second voltage between the second switch (26) and the ground potential (38);
a memory for storing one or more values (V1, V2) of the measured voltages; and
a processor being communicatively coupled to the memory and being configured to carry out the method in accordance with one of the preceding claims based on the measured voltage values (V1, V2).

11. Battery arrangement (20), comprising:

a battery pack (22) having a first pole (30), a second pole (32), and at least two battery cells (34) electrically arranged in series between the first pole (30) and the second pole (32);
a first switch (24) electrically arranged between the first pole (30) and a first resistor (R12), with the first resistor (R12) electrically coupling the first switch (24) to a ground potential (38); and
a second switch (26) electrically arranged between the second pole (32) and a second resistor (R22), with the second resistor (R22) electrically coupling the second switch (26) to the ground potential (38); and
a controller (28) in accordance with claim 10 being communicatively coupled to the first switch (24) and the second switch (26).

12. Computer program for localizing an earth-fault (EF) within a battery arrangement (20) in accordance with claim 11, the computer program comprising computer-readable instructions, which, when being carried out by the processor of the controller (28) according to claim 10, cause the controller (28) to carry out the method of one of claims 1 to 9.

13. Computer-readable medium, on which a computer program according to claim 12 is stored.

# Fig. 1

Fig. 2

Fig. 3

Fig. 4

Fig. 5

# Fig. 6

Europäisches
Patentamt

European
Patent Office

Office européen
des brevets

## EUROPEAN SEARCH REPORT

**Application Number**

**EP 24 20 5528**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/204678 A1 (IZUTANI ATSUSHI [JP] ET AL) 29 June 2023 (2023-06-29) | 1-6, 10-13 | INV. G01R31/52 |
| Y | * the whole document * | 7-9 | |
| Y | US 2005/264264 A1 (YANO JUNYA [JP] ET AL) 1 December 2005 (2005-12-01) * paragraph [0031] * | 7 | |
| Y | US 2013/176041 A1 (YANG JEONG HWAN [KR]) 11 July 2013 (2013-07-11) * paragraph [0056] - paragraph [0067]; figures 4-7 * | 8,9 | |

**TECHNICAL FIELDS SEARCHED (IPC)**

G01R

The present search report has been drawn up for all claims

| Place of search | Date of completion of the search | Examiner |
|---|---|---|
| Munich | 31 March 2025 | Mazagão Guerreiro, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 5528

This annex lists the patent family members relating to the patent documents cited in the above-mentioned European search report.
The members are as contained in the European Patent Office EDP file on
The European Patent Office is in no way liable for these particulars which are merely given for the purpose of information.

31-03-2025

| Patent document cited in search report | Publication date | Patent family member(s) | | Publication date |
|---|---|---|---|---|
| US 2023204678 A1 | 29-06-2023 | CN | 116338310 A | 27-06-2023 |
| | | DE | 102022109845 B3 | 22-06-2023 |
| | | JP | 2023094176 A | 05-07-2023 |
| | | US | 2023204678 A1 | 29-06-2023 |
| US 2005264264 A1 | 01-12-2005 | CN | 1702468 A | 30-11-2005 |
| | | DE | 102005024198 A1 | 16-02-2006 |
| | | JP | 4293942 B2 | 08-07-2009 |
| | | JP | 2005338010 A | 08-12-2005 |
| | | US | 2005264264 A1 | 01-12-2005 |
| US 2013176041 A1 | 11-07-2013 | CN | 103250061 A | 14-08-2013 |
| | | EP | 2616824 A2 | 24-07-2013 |
| | | JP | 2013537313 A | 30-09-2013 |
| | | KR | 20120029850 A | 27-03-2012 |
| | | US | 2013176041 A1 | 11-07-2013 |
| | | WO | 2012036498 A2 | 22-03-2012 |

EPO FORM P0459

For more details about this annex : see Official Journal of the European Patent Office, No. 12/82